Europäisches Patentamt

European Patent Office

Office européen des brevets

(11) Publication number: 0 474 068 A2

# EUROPEAN PATENT APPLICATION

(21) Application number: 91114180.2

(22) Date of filing: 23.08.91

(51) Int. Cl.5: H01L 21/28

(30) Priority: 23.08.90 JP 219948/90

(43) Date of publication of application:
11.03.92 Bulletin 92/11

(84) Designated Contracting States:
DE FR GB

(71) Applicant: Kabushiki Kaisha Toshiba
72, Horikawa-cho Saiwai-ku
Kawasaki-shi(JP)

(72) Inventor: Kinugawa, Masaaki, c/o Intellectual
Prop. Div.
Kabushiki Kaisha Toshiba, 1-1 Shibaura
1-chome
Minato-ku, Tokyo 105(JP)
Inventor: Nakayama, Takeo, c/o Intellectual
Prop. Div.
Kabushiki Kaisha Toshiba, 1-1 Shibaura
1-chome
Minato-ku, Tokyo 105(JP)

(74) Representative: Lehn, Werner, Dipl.-Ing. et al
Hoffmann, Eitle & Partner Patentanwälte
Arabellastrasse 4
W-8000 München 81(DE)

(54) A method for manufacturing a semiconductor device having insulating films.

(57) The present invention provides a method for manufacturing a semiconductor device having insulating films, comprising the steps of a first process of forming a first insulating film (7) on a main surface of a semiconductor substrate (6), a second process of forming a first conductive film (8) on said first insulating film (7), a third of selectively removing said first insulating film (7) on said semiconductor substrate (6) and said first conductive film (8), a fourth process of forming a second insulating film (10) whose thickness and material are different from those of said first insulating film (7) on said semiconductor substrate (6), a fifth process of forming a second conductive film (11) on said second insulating film (10), and a sixth process of selectively removing said second insulating film (10) on said semiconductor substrate (6) and said second conductive film (11), wherein said insulating films (7, 10) having a plurality of thicknesses and material are formed without forming said resist mask on said insulting film.

F I G. IA

F I G. IB

F I G. IC

F I G. ID

F I G. IE

F I G. IF

The present invention relates to a method for forming a plurality of gate insulating films, in which thicknesses and materials of circuit elements such as a field effect transistor are different from each other, formed on the same main surface of a semiconductor substrate, and more particularly to improvement of pressure resistance of the gate insulating films of the circuit elements and their reliability.

In general, in a semiconductor integrated circuit, a power supply voltage is applied from the external unit, and a plurality of circuit elements formed in the circuit is driven.

Generally, in view of TTL (Transistor Transistor Logic) compatibility, such a power supply voltage is set to 5V.

However, if the power supply voltage of 5V is directly applied as the elements are made fine and high performance is achieved, reliability of the gate insulating films cannot be sufficiently ensured. In such a case, there is used a voltage down converter. More specifically, this is a method in which the power supply voltage of 5V is applied from the external unit, the element, which is not relatively fine, is operated on 5V and the drop power supply voltage of, for example, 3V is applied to other fine elements, thereby operating these elements and obtaining high performance.

In this case, it is preferable that the gate insulating films to which the external voltage is directly applied may be formed to be thicker in view of their reliability. On the other hand, it is preferable that the gate insulating films to which the drop voltage is applied may be formed to be thinner in view of their performance.

Therefore, it is required that a gate electrode using gate insulating films whose thicknesses or materials are different be formed.

Particularly, in order to obtain a circuit characteristic having high performance, there is often used a lamination structure in which metal or metallic oxide film (silicide) is formed on a polycrystalline silicon as a gate electrode. In this case, it is required that a gate electrode using gate insulating films whose thicknesses or materials are different be formed.

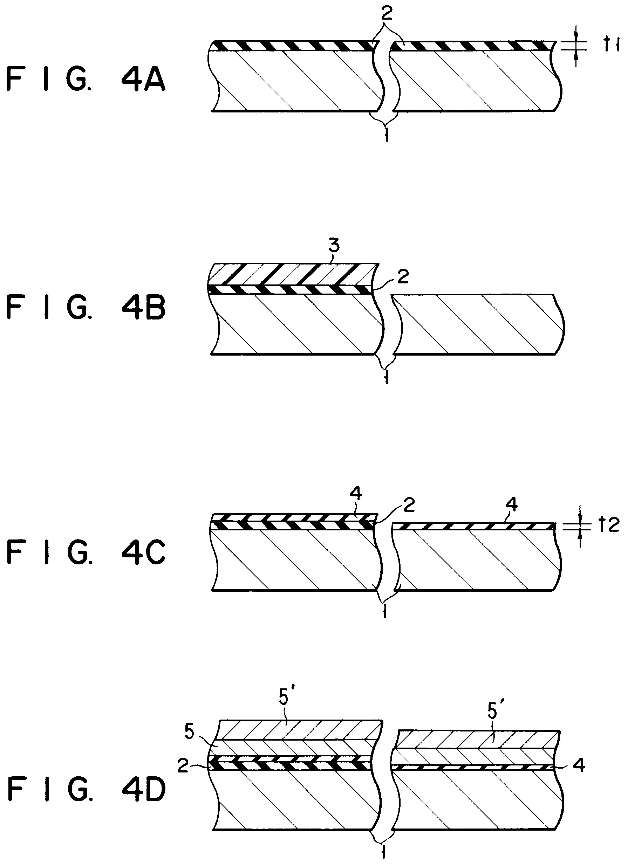

Figs. 4A to 4D show one prior art illustrating processes in which gate insulating films having two kinds of thicknesses are formed on the same semiconductor substrate. In the process shown in Fig. 4A, the main surface of the semiconductor substrate 1 is thermally oxidized and an insulating film 2 having a thickness t1 is formed on the entire main surface.

In the process shown in Fig. 4B, a mask made of a resist 3 is selectively formed on the insulating film 2. Thereafter, wet-etching is performed, so that the insulating film 2, which is exposed without being covered with the mask, is removed, and a first gate insulating film is formed.

In the process shown in Fig. 4C, the surface of the semiconductor substrate is thermally oxidized again after removing the resist 3, and an insulating film 4 having a thickness t2 is formed on the entire main surface.

In the process shown in Fig. 4D, on the insulating film 4, there is formed a polycrystalline silicon film 5 serving as an electrode, and a metallic silicide film 5' is formed thereon.

According to the above-mentioned processes, on the same main surface, there can be formed the first gate insulating film having thickness t1, and the second gate insulating film having a thickness in which thicknesses t1 and t2 are combined.

In the process shown in Fig. 4B, in order to selectively remove the second insulating film, the mask is formed of the resist to be directly in contact with the second insulating film.

Regarding the resist material, there is generally used a resist of cinnamic acid or a rubber resist. In either resist, a large amount of alkali metal and heavy metal are contained.

Therefore, in a case where the resist is directly formed on the insulating film in the above process, this exerts unfavorable influence on the insulating film with which the resister is in contact. More specifically, since metal contained in the resist penetrates the insulating film, a property of the insulating film is changed, an initial pressure resistance is deteriorated, and long-time reliability of the pressure resistance of the insulating film is also deteriorated. In particular, if a UV cure or a brake treatment is performed in order to harden the resist, the metal tends to easily penetrate the insulating film. Moreover, as the insulating film is made thicker, influence of the metal including in the resist upon the insulating film becomes larger.

Due to deterioration of the pressure resistance of the insulating film, leakage is generated between the layers of the integrated circuit and the integrated circuit, and the circuit elements break down.

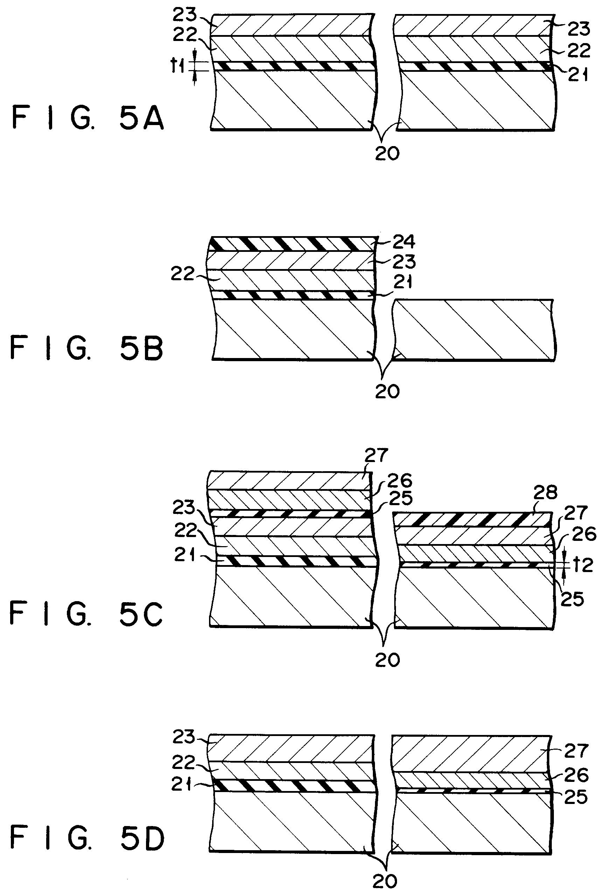

Figs. 5A to 5D show the method of the other prior art.

Specifically, in the process shown in Fig. 5A, a main surface of a semiconductor substrate 20 is thermally oxidized, and an insulating film 21 having a thickness t1 is formed on an entire main surface. Moreover, a poly-si film 22 and a metallic silicide film 23 are formed thereon.

In the process shown in Fig. 5B, there is selectively formed a resist mask 24, which is made of a resist, on the lamination structure having the insulating film 21 - poly-si film 22 - metallic silicide film 23. Thereafter, a dry-etching is performed, thereby exposing the semiconductor substrate 20 in a portion which is not covered with the mask.

In the process shown in Fig. 5C, the resist mask 24 is removed. Thereafter, the main surface of the substrate is thermally oxidized again, thereby forming an insulating film 25 having a thickness t2. Moreover, a poly-si film 26 and a metallic silicide film 27 are formed thereon.

In the process shown in Fig. 5D, there is selectively formed a resist mask 28, which is made of a resist, on the metallic silicide film 27. Thereafter, a dry-etching is performed, thereby removing the insulating film 25 in a portion, which is not covered with the mask, the poly-si film 26, and the metallic silicide film 27. Thereafter, the resist mask 28 is removed.

Therefore, on the insulating film 25, there is formed a polycide film (lamination film having poly-si film 27 and silicide film 27) serving as an electrode.

By use of the above-mentioned processes, on the same main surface, there can be formed the first gate insulating film having thickness t1, and the second gate insulating film having a thickness in which thicknesses t1 and t2 are combined.

However, since the silicide film is laminated two in the above-mentioned processes, there may occurs increase in the number of the processes and manufacturing cost. Moreover, since the metallic silicide film 27 is exposed in forming the second gate insulating film 25, such metal is contained in the gate insulating film and pressure resistance is lowered. Therefore, similar to the first prior art, there occurs the problem in the integrated circuit.

Accordingly, an object of the present invention is to provide a semiconductor device having high reliability by use of a forming method for preventing deterioration of an initial pressure resistance of an insulating film formed on the semiconductor substrate and that of the long-time reliability of the pressure resistance of the insulating film.

According to the present invention, there is provided a method for manufacturing a semiconductor device having insulating films, comprising the steps of a first process of forming a first insulating film on a main surface of a semiconductor substrate; a second process of forming a first conductive film on the first insulating film; a third process of selectively removing the first insulating film on the semiconductor substrate and the first conductive film; a fourth process of forming a second insulating film whose thickness and material are different from those of the first insulating film on the semiconductor substrate; a fifth process of forming a second conductive film on the second insulating film; a sixth process of selectively removing the second insulating film on the semiconductor substrate and the second conductive film; a seventh process of forming a metallic film or a metallic silicide film on the entire surface; and an eighth process of selectively removing the metallic film or the metallic silicide film.

This invention can be more fully understood from the following detailed description when taken in conjunction with the accompanying drawings, in which:

Figs. 1A to 1F are views showing forming processes of a semiconductor device according to the manufacturing method of the present invention;

Fig. 2 is a distribution view showing distribution of pressure resistance of a gate insulating film of the semiconductor device manufactured by the manufacturing method of the present invention;

Fig. 3 is a distribution view showing distribution of pressure resistance of a gate insulating film of the semiconductor device manufactured by a conventional manufacturing method;

Figs. 4A to 4D are views showing forming processes of a semiconductor device according to the conventional manufacturing method; and

Figs. 5A to 5D are views showing forming processes of a semiconductor device according to the other conventional manufacturing method.

An embodiment of the present invention will be explained with reference to the drawings.

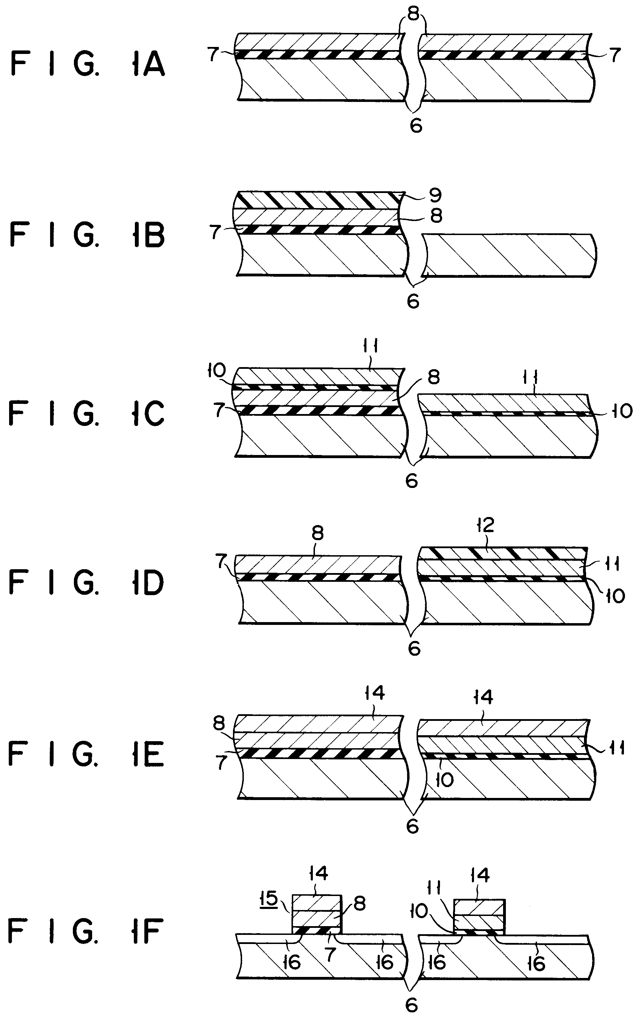

Figs. 1A to 1F are process views showing the formation of the circuit elements of the semiconductor device of one embodiment of the present invention.

In a process shown in Fig. 1A, a general element isolating region (not shown) is formed on a main surface of a P type semiconductor substrate 6 having a face index (100). Thereafter, the P type semiconductor substrate 6 is placed under atmosphere of dry gaseous oxygen at 800°C, thereby a first gate insulating film 7 having a thickness of 100 Å is formed on the main surface. Moreover, by use of a CVD device or a sputtering device, a polycrystalline silicon film (Poly-Si) 8 having a thickness of 1000 Å is deposited on the first gate insulating film 7.

In a process shown in Fig. 1B, a mask, which is made of a resist 9, is selectively formed on the polycrystalline silicon film 8 by a photolithography. Then, by use of dry etching and wet etching, there is removed the first gate insulating film 7 and the polycrystalline silicon film 8, which are formed on predetermined regions such as a region where a second gate insulating film to be explained later is formed and a region where a burying contact with the substrate is formed.

In a process shown in Fig. 1C, the resist 9 is removed from the substrate. Then, the main surface side is placed under atmosphere of dry gaseous oxygen at 850°C, thereby a second gate insulating film 10 having a thickness of 150 Å is formed on the entire surface of the main surface side. Moreover, a polycrystalline silicon film 11 having a thickness of 1000 Å is deposited on the second gate insulating film 10.

In a process shown in Fig. 1D, a resist 12, which is made of a resist 12, is selectively formed on the polycrystalline silicon film 11. Thereafter, the second gate insulating film 10, which is other than the region where a gate electrode is formed, and the polycrystalline silicon film 11 are removed by use of dry etching and wet etching.

By these forming processes shown in Figs. 1A to 1D, on the same main surface of the semiconductor substrate, there are formed the gate insulating films whose thicknesses are different, that is, the first insulating film 7 having the thickness of 100 Å and the second insulating film 10 having thickness of 110 Å.

Next, in a process shown in Fig. 1E, energy of 30 KeV is applied to the semiconductor substrate, and arsenic having a does of $1 \times 10^{16}$ cm$^{-2}$ is ion-implanted from the polycrystalline silicon films 8 and 11. Thereafter, an anneal-treatment is performed under nitrogen N2 atmospheric gas at 900°C for 10 min.

Thereby, the polycrystalline silicon films 8 and 11 are N-type-polycrystallized.

In a process shown in Fig. 1F, a tungsten silicide film having a thickness of 1000 Å on the polycrystalline silicon films 8 and 11. Moreover, a resist (not shown) is selectively formed on these silicon films by the photolithography. Thereafter, the polycrystalline silicon films 8, 11, the tungsten silicide film 14, and the predetermined region of the gate insulating film 7 are removed by dry etching, thereby forming a gate 15. Thereafter, energy of 60 KeV is applied to the semiconductor substrate, and arsenic having a does of $5 \times 10^{15}$ cm$^{-2}$ is ion-implanted. Thereafter, an anneal-treatment is performed under nitrogen N2 atmospheric gas at 900°C for 10 min. Thereby, an N+ layer 16 of the source and drain of the transistor is formed. Thereafter, a general circuit wire, which is made of metallic wire such as aluminum, is formed, and an integrated circuit is completed.

As mentioned above, in a case where a plurality of gate insulating films whose thickness and material are different is formed on the same main surface of the semiconductor substrate, the resist is patterned on the polycrystalline silicon film serving as a gate electrode in order to avoid the conventional process in which the resist is directly patterned on the oxide film. Thereby, the circuit element is formed.

The property of the pressure resistance of the gate insulating film will be explained by comparing the property of the pressure resistance of the gate insulating film according to the conventional manufacturing method with that of the gate insulating film according to the manufacturing method of the present invention.

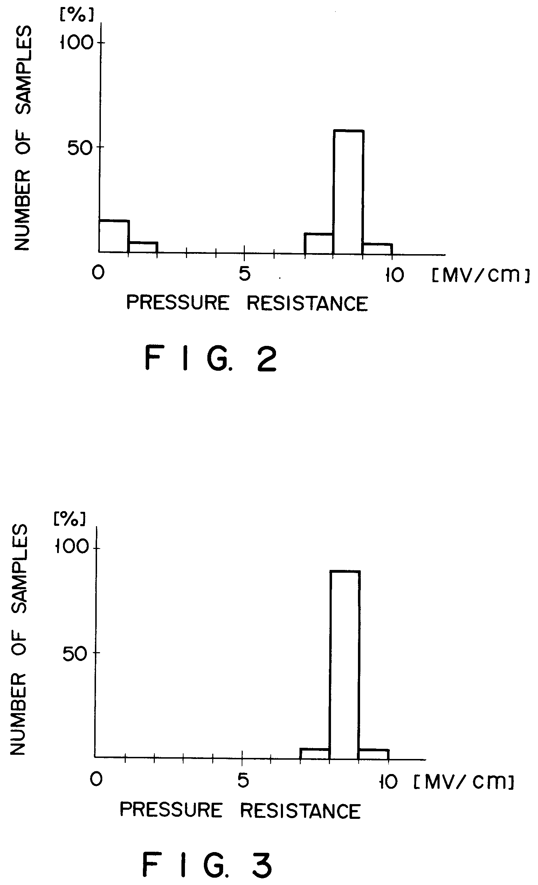

Fig. 2 is the property of the pressure resistance of the gate insulating film having a thickness of t3 in the semiconductor device according to the manufacturing method of the present invention. Fig. 3 is a distribution view showing distribution of pressure resistance of the gate insulating film of the semiconductor device manufactured by a conventional manufacturing method. In Figs. 2 and 3, the horizontal axis shows a value of the pressure resistance of the gate insulating film, and a vertical axis shows the number of measuring samples wherein the total number of measuring samples is 100%.

As shown in Fig. 2, about 90% of the measured semiconductor devices according to the manufacturing method of the present invention obtain the pressure resistance value of 8 MV/cm range. Then, about 10% of the measured semiconductor devices obtain before or after the above pressure resistance value.

As shown in Fig. 3, about 70% of the measured semiconductor devices according to the conventional manufacturing method obtain the pressure resistance value of 8 MV/cm range. However, about 30% of the measured semiconductor devices obtain the pressure resistance value of 0 to 2 MV/cm. This indicates that the initial pressure resistance of the semiconductor device is deteriorated and the pressure resistance is defective. Due to this, the semiconductor device is in substantially a shorting state.

As mentioned above, according to the present invention, there can be provided a semiconductor device wherein an initial pressure resistance of an electrode formed on a semiconductor substrate can be prevented from being deteriorated and long-time reliability of the pressure resistance can be obtained.

## Claims

1. A method for manufacturing a semiconductor device having insulating films, characterized by comprising the steps of:

a first process of forming a first insulating film (7) on a main surface of a semiconductor substrate (6);

a second process of forming a first conductive film (8) on said first insulating film (7);

a third process of selectively removing said first insulating film (7) on said semiconductor substrate (6) and said first conductive film (8);

a fourth process of forming a second insulating film (10) whose thickness and material are different from those of said first insulating film (7) on said semiconductor substrate (6);

a fifth process of forming a second conductive film (11) on said second insulating film (10);

a sixth process of selectively removing said second insulating film (10) on said semiconductor substrate (6) and said second conductive film (8);

a seventh process of forming a metallic film (14) or a metallic silicide film on the entire surface; and

an eighth process of selectively removing at least said metallic film (14) or said metallic silicide film.

2. The method according to claim 1, characterized in that material of said second insulating film (10) in said fourth process is different from that of said first insulating film (7).

3. The method according to claim 1, characterized in that material of said second insulating film (10) in said fifth process is different from that of said first conductive film (7).

4. The method according to claim 1, characterized in that said first conductive film (8) and said second insulating film (10) are made of aluminum.

5. The method according to claim 1, characterized in that said first conductive film (8) and said second conductive film (11) are made of polysilicon.

F I G. 1A

F I G. 1B

F I G. 1C

F I G. 1D

F I G. 1E

F I G. 1F

F I G. 2

F I G. 3

F I G. 4A

F I G. 4B

F I G. 4C

F I G. 4D

FIG. 5A

FIG. 5B

FIG. 5C

FIG. 5D